# EUROPEAN PATENT APPLICATION

(11) **EP 4 741 922 A1**
(43) Date of publication of application: **13.05.2026**
(21) Application number: 24211161.5
(22) Date of filing: 06.11.2024
(51) Int. Cl.: G03F 7/00

(54) **WAVELENGTH SELECTION SYSTEM**

(71) Applicant: ASML Netherlands B.V., 5500 AH Veldhoven (NL)
(72) Inventor: ASSENDELFT, Joep, 5500 AH Veldhoven (NL); ÖZTÜRK, Fahri Emre, 5500 AH Veldhoven (NL); ZHOU, Zili, 5500 AH Veldhoven (NL)
(74) Representative: ASML Netherlands B.V.

(57) **Abstract**

A wavelength selection system comprising an actuatable reflector configured to reflect a radiation beam, and an optical filter configured to receive the reflected radiation beam, wherein the actuatable reflector is moveable between different orientations which direct the radiation beam to different positions on the optical filter, or at different angles of incidence on the optical filter, such that the optical filter selectively filters different wavelengths of the radiation beam, and wherein the wavelength selection system further comprises a dispersive element configured to apply wavelength dispersion to the radiation beam before the radiation beam is incident upon the optical filter.

## Description

### FIELD

The present invention relates to a wavelength selection system. The wavelength selection system may form part of a metrology tool. The wavelength selection system may form part of a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

Metrology tools, such as a scatterometer, topography measurement system, or position measurement system are used to measure properties of substrates. The measurements may be performed after exposure of a substrate. The measurements may be used to adjust operation of the lithographic apparatus that exposed the substrate to improve pattern reproduction. Adjustments may include modifying the illumination scheme and/or, adjusting the projection optics.

The properties of the radiation used by a metrology tool may affect the type and quality of measurements that may be performed. For some applications, it may be advantageous to use multiple radiation wavelengths to measure a substrate. Multiple different wavelengths may be able to propagate, irradiate, and scatter off a metrology target with no or minimal interference with other wavelengths. Therefore different wavelengths may for example be used to obtain more metrology data. The different wavelengths may for example be provided as a sequence of different wavelengths (i.e. a series of wavelengths). Different radiation wavelengths may also be able to interrogate and discover different properties of a metrology target.

A broadband radiation source may provide a broadband radiation beam. A wavelength selection system may be used to select a wavelength from the broadband radiation beam to illuminate a substrate for a measurement, and may then be used to select another wavelength to illuminate the substrate for a subsequent measurement.

It may be difficult and/or expensive to generate radiation with desired wavelengths.

### SUMMARY

According to a first aspect of the invention there is provided a wavelength selection system comprising an actuatable reflector configured to reflect a radiation beam, and an optical filter configured to receive the reflected radiation beam, wherein the actuatable reflector is moveable between different orientations which direct the radiation beam to different positions on the optical filter, or at different angles of incidence on the optical filter, such that the optical filter selectively filters different wavelengths of the radiation beam, and wherein the wavelength selection system further comprises a dispersive element configured to apply wavelength dispersion to the radiation beam before the radiation beam is incident upon the optical filter.

Because the radiation beam is wavelength dispersed when it is incident upon the optical filter, the intensity of radiation at the optical filter is reduced. This advantageously reduces a risk of damage being caused to the optical filter. For a given position or angle of the radiation beam on the optical filter the selectively filtered wavelengths may comprise a central wavelength and an associated bandwidth. Different positions of the radiation beam on the optical filter may provide an output radiation beam having different central wavelengths.

The optical filter may be a continuously variable optical filter having a wavelength transmission which varies continuously as a function of position on the optical filter.

The dispersive element may be configured to provide the radiation beam with a wavelength distribution which increases in an opposite direction to a direction in which a filter transition wavelength of the continuously variable optical filter increases.

The continuously variable optical filter may be one of a pair of continuously variable optical filters that are provided in series.

At least one of the continuously variable optical filters may be actuatable in a direction which is generally perpendicular to an optical axis of the wavelength selection system.

The optical filter may provide filtering determined by an angle of incidence of the radiation beam, and wherein a pair of focusing lenses are provided between the actuatable reflector an the optical filter.

The pair of focusing lenses may be configured to form a demagnified image of the radiation beam at the actuatable reflector.

The actuatable reflector may be configured to move the radiation beam in two dimensions.

The optical filter may be one of a plurality of optical filters selectable through movement of the radiation beam by the actuatable reflector.

The dispersive element may be located upstream of the actuatable reflector.

The dispersive element may be a prism.

The prism may be actuatable.

The prism may be rotatable and/or moveable in a direction generally perpendicular to the radiation beam.

The dispersive element may be a grating.

The wavelength selection system may further comprise a second actuatable reflector located downstream of the optical filter, the second actuatable reflector being configured to direct a filtered radiation beam received from the optical filter to an output location.

The wavelength selection system may further comprise a second dispersive element located downstream of the optical filter, the second dispersive element being configured to remove or reduce any wavelength dispersion present in the filtered radiation beam received from the optical filter.

According to a second aspect of the invention there is provided a metrology tool comprising the wavelength selection system of the first aspect.

According to a third aspect of the invention there is provided a lithographic apparatus comprising the wavelength selection system of the first aspect or the metrology tool of the second aspect.

According to a fourth aspect of the invention there is provided a method comprising using an actuatable reflector to direct a radiation beam onto an optical filter, the radiation beam being incident on the optical filter at a position or with an angle of incidence that is selected via an orientation of the actuatable reflector, such that the optical filter selectively filters different wavelengths of the radiation beam, wherein the method further comprises applying a wavelength dispersion to the radiation beam before the radiation beam is incident upon the optical filter.

Because the radiation beam is wavelength dispersed when it is incident upon the optical filter, the intensity of radiation at the optical filter is reduced. This advantageously reduces a risk of damage being caused to the optical filter. For a given position or angle of the radiation beam on the optical filter the selectively filtered wavelengths may comprise a central wavelength and an associated bandwidth. Different positions of the radiation beam on the optical filter may provide an output radiation beam having different central wavelengths.

The optical filter may be a continuously variable optical filter having a wavelength transmission which varies continuously as a function of position on the optical filter.

The dispersive element may provide the radiation beam with a wavelength distribution which increases in an opposite direction to a direction in which a filter transition wavelength of the continuously variable optical filter increases.

The continuously variable optical filter may be one of a pair of continuously variable optical filters that are provided in series.

The method may further comprise moving at least one of the continuously variable optical filters in a direction which is generally perpendicular to an optical axis of the wavelength selection system to adjust a bandwidth of radiation transmitted by the continuously variable optical filters.

The optical filter may provide filtering determined by an angle of incidence of the radiation beam, and wherein a pair of focusing lenses are provided between the actuatable reflector an the optical filter.

The pair of focusing lenses may form a demagnified image of the radiation beam at the actuatable reflector.

The actuatable reflector may move the radiation beam in two dimensions.

The optical filter may be one of a plurality of optical filters selectable through movement of the radiation beam by the actuatable reflector.

The dispersive element may be located upstream of the actuatable reflector.

The dispersive element may be a prism.

The prism may be actuatable rotatable and/or moveable in a direction generally perpendicular to the radiation beam.

The dispersive element may be a grating.

The method may further comprise using a second actuatable reflector located downstream of the optical filter to direct a filtered radiation beam received from the optical filter to an output location.

The method may further comprise using a second dispersive element located downstream of the optical filter to remove or reduce any wavelength dispersion present in the filtered radiation beam received from the optical filter.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic representation of a scatterometer which may include a radiation source according to an embodiment of the invention;
- Figure 5 depicts a schematic representation of a dark field scatterometer which may include a radiation source according to an embodiment of the invention;
- Figure 6 depicts an alignment sensor which may include a radiation source according to an embodiment of the invention;
- Figure 7 depicts a schematic representation of a wavelength selection system according to an embodiment of the invention;
- Figure 8 depicts operation of an optical filter pair of the wavelength selection system;
- Figure 9 depicts operation of a long pass filter of the wavelength selection system; and
- Figure 10 depicts a schematic representation of a wavelength selection system according to an alternative embodiment of the invention.

### DETAILED DESCRIPTION

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

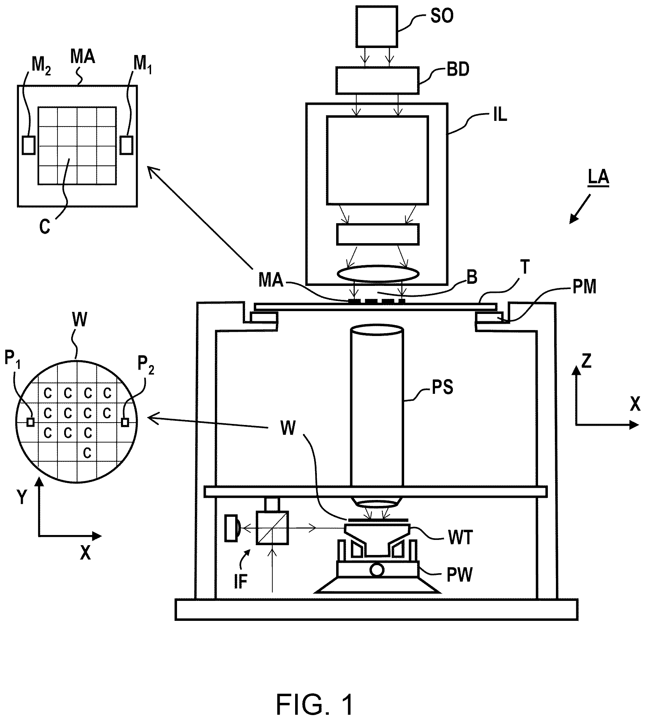

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

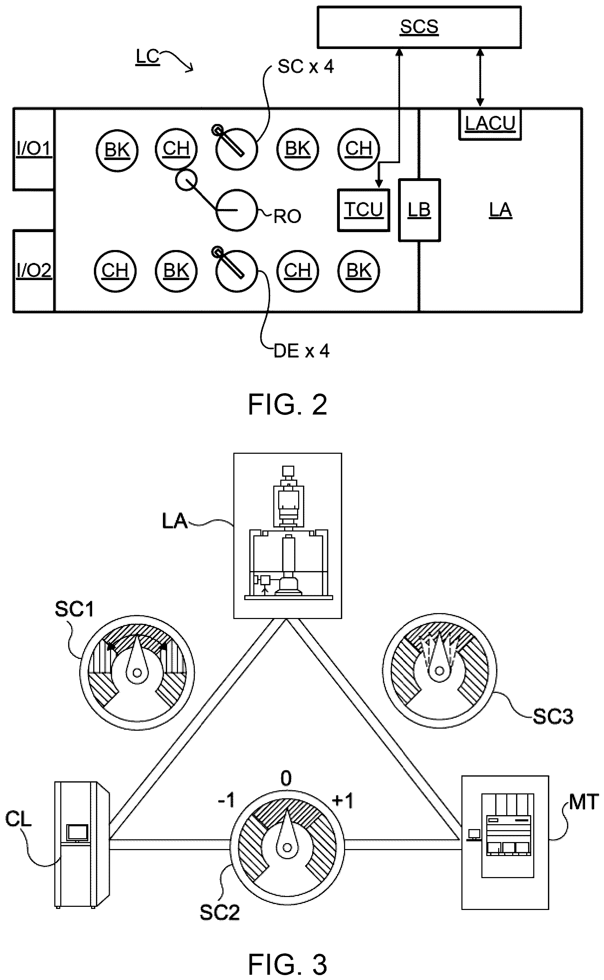

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology tool, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization state. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

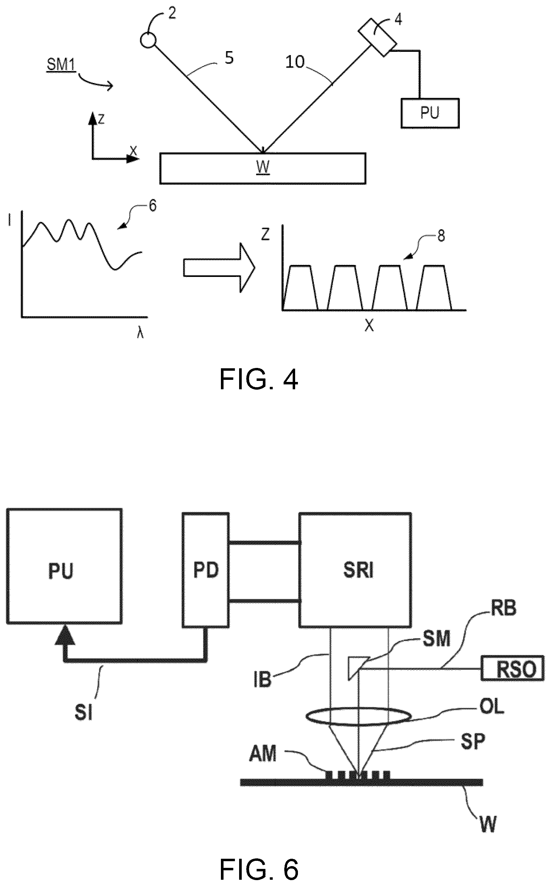

A metrology apparatus, such as a scatterometer SM1, is depicted in figure 4. It comprises a broadband (white light) radiation projector 2 which projects radiation onto a substrate W. The reflected or scattered radiation is passed to a spectrometer detector 4, which measures a spectrum 6 (i.e. a measurement of intensity In1 as a function of wavelength λ) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray and visible to near-IR wave range.

A topography measurement system, level sensor or height sensor, and which may be integrated in the lithographic apparatus, is arranged to measure a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

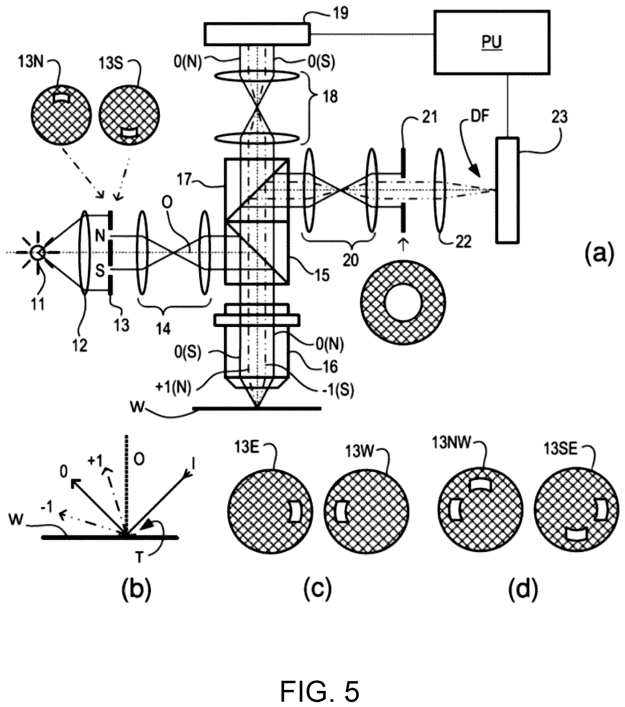

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lens 12, 14 and objective lens 16. These lens are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lens 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or + 1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting lens onto a mark, such as mark AM located on substrate W, as an illumination spot SP. In this example the diverting lens comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting lens, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

Metrology and/or inspection tools (also referred to as measurement tools) such as the ones described above often use radiation to obtain measurement data. Depending on the measurement target and the properties to be measured, different types of radiation may be used. One differing property of radiation is the wavelength(s) used to obtain a measurement, as different wavelengths may provide different information about a measurement target. Some measurement tools may use broadband radiation, such as supercontinuum radiation, either to measure using broadband radiation, or to be able to tune and select the measurement wavelength(s) to be used. Depending on the range of output wavelengths and properties of the broadband source, difference methods may be used to obtain the broadband radiation. In some implementations for generating broadband radiation, nonlinear effects may be used to broaden narrow wavelength range input radiation (also referred to as pump radiation). Different known setups and methods exist to achieve nonlinear broadening. Often these methods rely on the confinement of the pump radiation to achieve high intensities needed to experience significant nonlinear effects.

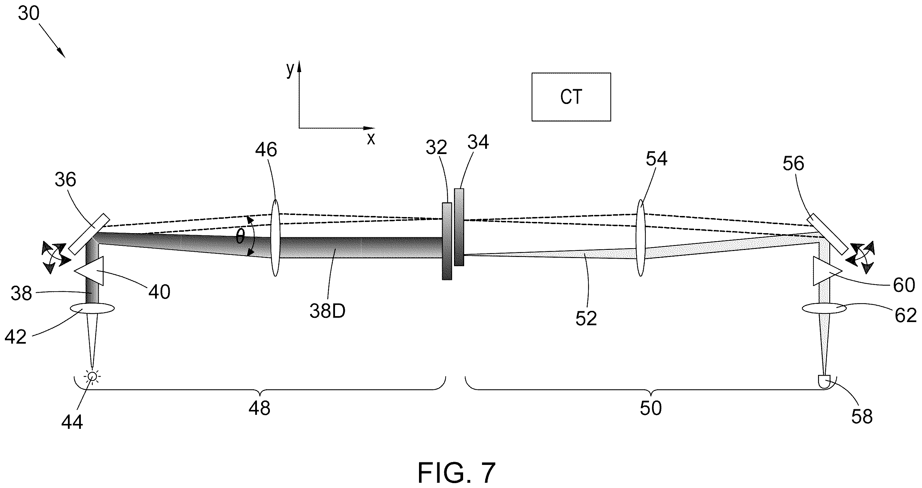

In order to provide a radiation source that is able to switch between desired wavelengths, the radiation source may include a wavelength selection system. A wavelength selection system 30 according to an embodiment of the invention is schematically depicted in Figure 7. The wavelength selection system 30 comprises a first continuously variable optical filter 32 and a second continuously variable optical filter 34. In this embodiment the first continuously variable optical filter 32 is a long wavelength pass filter, and may be referred to hereafter as the long pass filter 32. In this embodiment the second continuously variable optical filter 34 is a short wavelength pass filter, and may be referred to hereafter as the short pass filter 34. The long pass filter 32 and the short pass filter 34 may be referred to as the filter pair 32, 34 for brevity. In an alternative embodiment, the short pass filter 34 may be located in front of the long pass filter 32. Other forms of optical filter may be used (as described further below).

Cartesian coordinates are used in this document to aid description of embodiments of the invention. The Cartesian coordinates are not intended to imply that the wavelength selection system 30 must have a particular orientation. Referring to the Cartesian coordinates in Figure 7, the filter pair 32, 34 provide wavelength selection in the Y-direction. Taking the long pass filter 32 as an example, a filter transition from blocking to transmitting occurs at longer and longer wavelengths as the Y-direction decreases. The same applies for the short pass filter 34. The Y-direction may alternatively be referred to as a direction which is perpendicular to an optical axis of the wavelength selection system 30. The Y-direction may be referred to as the wavelength selection direction. The optical axis of the wavelength selection system 30 may be referred to as the X-direction. These definitions may apply between actuatable mirrors 36, 56 (these are described further below).

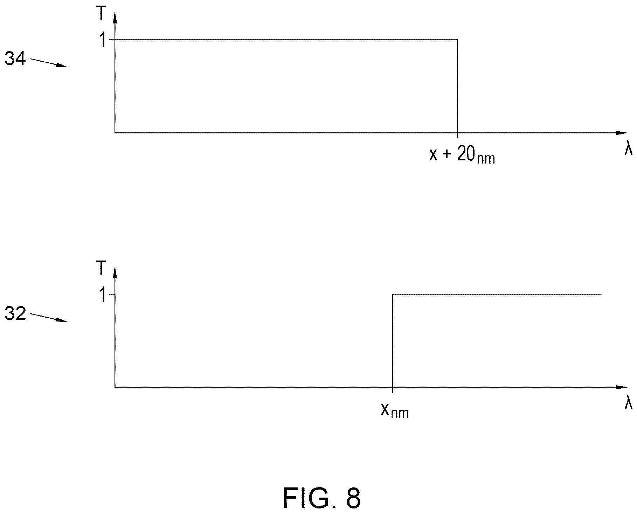

The long pass filter 32 and the short pass filter 34 are offset from one another in the wavelength selecting direction (the Y-direction). The offset between the long pass filter 32 and the short pass filter 34 affects a bandwidth of radiation which is transmitted by the filters. This is explained further below in connection with Figure 8.

The wavelength selection system further comprises an actuatable mirror 36 (which is an example of an actuatable reflector). The actuatable mirror 36 is moveable between different orientations which direct a radiation beam 38 to different incident locations upon the filter pair 32, 34. The actuatable mirror 36 in this embodiment is rotatable about an axis which extends in the Z-direction, thus causing movement of the radiation beam 38 along the Y-direction. Since the filter pair 32, 34 provide wavelength selection in the Y-direction, movement of the input radiation beam 38 in the Y-direction changes the wavelengths of radiation that are transmitted by the filter pair. That is, the actuatable mirror 36 provides movement of the radiation beam 38 in the wavelength selection direction. The orientation of the actuatable mirror 36 may be controlled by a controller CT.

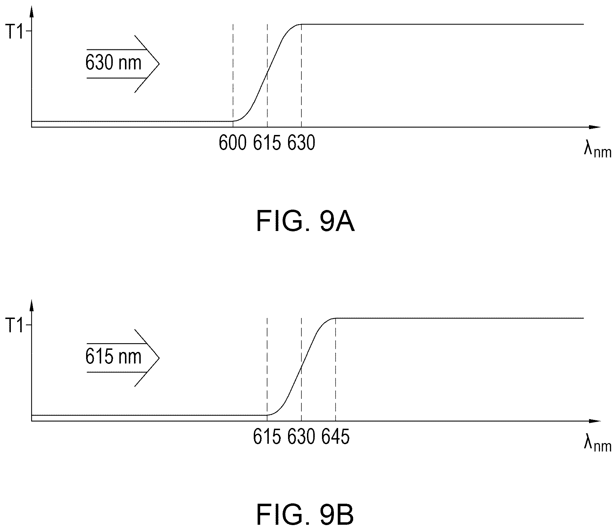

A prism 40 (which is an example of a dispersive element) is located upstream of the actuatable mirror 36. The prism 40 is configured to disperse the radiation beam 38 into component wavelengths and thereby form a dispersed radiation beam 38D. This is schematically indicated in Figure 7 by bands of different shading which are intended to represent different wavelengths. The dispersed radiation beam 38D has a wavelength distribution in which the wavelength increases in an opposite direction to the direction in which the filter transition wavelength of the filter pair 32, 34 increases. In this example, the wavelength of the dispersed radiation beam 38D increases in the Y-direction whereas a filter transition wavelength of the filter pair 32, 34 decreases in the Y-direction. This arrangement advantageously improves wavelength selectivity provided by the filter pair 32, 34, as explained further below in connection with Figure 9. In another embodiment the wavelength of the dispersed radiation beam 38D decreases in the Y-direction whereas the filter transition wavelength of the filter pair 32, 34 increases in the Y-direction. This provides the same improvement of wavelength selectivity. In other embodiments, the wavelength distribution may increase in the same direction as the filter transition wavelength of the filter pair 32, 34. However, this arrangement will not improve wavelength selectivity.

In an embodiment, the actuatable mirror 36 is moveable in multiple directions (not merely rotatable about an axis). The actuatable mirror 36 may be moveable to move the dispersed radiation beam 38D in the Z-direction in addition to moving the dispersed radiation beam in the Y-direction. The actuatable mirror 36 may be movable to move the dispersed radiation beam 38D to different desired positions in the YZ plane. That is, the dispersed radiation beam 38D may be moved across the optical filter in two dimensions. In such an embodiment, one or more additional filter pairs (or other filters) may be provided, for example separated from the filter pair 32, 34 in the Z-direction. This advantageously provides additional filtering options. The additional filtering options may be different wavelength filters or polarizing filters. Different attenuation options may advantageously be provided, e.g. separated in the Z-direction.

Figure 8 is a pair of graphs which schematically depict operation of the first continuously variable filter 32 and the second continuously variable filter 34. In the graphs transmittance is normalized to 1. The first continuously variable optical filter 32 is a long pass filter, and thus transmittance rises from a low value (which may be zero or close to zero) for short wavelengths to a normalised transmittance of 1 at long wavelengths. The wavelength at which transmittance increases depends upon the position at which the radiation beam 38 is incident on the long pass filter 32. In the depicted example of Figure 8 the radiation beam is incident at a location at which the transition from blocking to transmitting is at the wavelength × nm. For ease of explanation the transition from blocking to transmitting is depicted as a step-function (although in practice this performance is not achievable as is discussed further below). Radiation with a wavelength longer than × nm is transmitted by the long pass filter 32 and radiation with a wavelength shorter than × nm is blocked. Thus, a partially filtered radiation beam is provided.

The partially filtered radiation beam is incident upon the short pass filter 34. The short pass filter 34 may be positioned such that the radiation beam is incident at a location on the short pass filter where the transition from transmission to blocking is at the wavelength x + 20nm. That is, the short pass filter 34 transmits wavelengths shorter than x + 20nm and blocks wavelengths longer than x + 20nm. or shorter. This offset in the Y-direction between the short pass filter 34 and the long pass filter 32 allows for transmission of a filtered radiation beam having a bandwidth of 20nm.

A central wavelength of the filtered radiation beam is determined by the location at which the radiation beam is incident upon the long pass filter 32. For brevity, a central wavelength of a filtered radiation beam may be referred to as the wavelength of the filtered radiation beam. A bandwidth of radiation either side of the central wavelength will be present. The term "wavelength of the filtered radiation beam" is not intended to imply that a bandwidth either side of that wavelength is not present.

As will be appreciated from Figure 8, the size of the Y-direction offset between the short pass filter 34 and the long pass filter 32 determines the bandwidth of the radiation which is transmitted by the filter pair. Increasing the offset will increase the bandwidth and decreasing the offset will reduce the bandwidth.

In practice, as mentioned above, the long pass filter 32 and short pass filter 34 do not provide a step-function response, but instead have a roll-off in their response. In other words, there is a gradual transition from blocking to transmitting. This roll-off will act to impose a minimum bandwidth achievable from the filter pair 32, 34 for an incident undispersed broadband radiation beam. The minimum bandwidth may for example be around 20-30 nanometres (full width half maximum (FWHM) of the filtered radiation beam). Embodiments of the invention may advantageously reduce the minimum bandwidth of the filtered radiation beam. This is achieved by providing the dispersed radiation beam 38D with a wavelength distribution which increases in an opposite direction to the direction in which the filter transition wavelength of the filter pair 32, 34 increases, as described further below in connection with Figure 9.

Referring again to Figure 7, the wavelength selection system further comprises beam conditioning lens 42 provided upstream of the prism 40. The beam conditioning lens 42 may for example be configured to collimate the input radiation beam 38. The input radiation beam 38 may be provided by a source 44. The source 44 may for example be a supercontinuum source, a laser pumped plasma source, a white light LED, an incandescent lamp, or any other suitable light source that generates broadband light. The source 44 may for example provide radiation in a range of 400 nm to 1600 nm, or a range of 500 nm to 1050 nm, or a range of 450 nm to 900 nm. A focusing lens 46 is located between the actuatable mirror 36 and the filter pair 32, 42.

The various elements which are upstream of the filter pair 32, 34 may be referred to as being on the input side 48 of the wavelength selection system 30. An output side 50 of the wavelength selection system will now be described.

The filter pair 32, 34 filter the dispersed radiation beam 38D to provide a filtered radiation beam (also referred to as an output radiation beam 52 or output beam 52) having a desired central wavelength and a desired bandwidth. For brevity, in this description the output beam 52 may be referred to as having a desired wavelength. A focusing lens 54 is located downstream from the filter pair 32, 34. A second actuatable mirror 56 is located downstream of the focusing lens 54. The second actuatable mirror 56 has an orientation which may be controlled by the controller CT. The second actuatable mirror 56 may be rotatable about an axis which extends in the Z-direction. The second actuatable mirror 56 may be moveable in multiple directions, e.g. in the same manner as the first actuatable mirror 36. The second rotatable mirror 56 may be moved (e.g. rotated) to compensate for movement of the dispersed radiation beam 38D and thus movement of the output beam 52 caused by the first actuatable mirror 36. The compensation provided by the second actuatable mirror 56 may be such that the output beam 52 is consistently directed to the same location. The location may be referred to as an output location 58.

A second prism 60 is provided downstream of the second actuatable mirror 56. The second prism 60 is configured to remove or reduce any wavelength dispersion present in the output beam 52. Focusing lens 62 is located downstream of the second prism 60 and is configured to focus the output beam 52 at the output location 58. An optical fiber may be provided at the output location 58.

In some embodiments the second prism 60 may be omitted. Where this is the case some wavelength dispersion may remain in the output beam 52, and different wavelengths of the output beam may propagate in different directions. This may be compensated for using an additional actuatable mirror. A benefit of not having the second prism 60 is that losses caused by the radiation beam travelling through the prism are avoided.

Elements provided on the input side 48 of the wavelength selection system 30 may be referred to as input side elements. Thus, the wavelength selection system 30 comprises input beam conditioning lens 44, input side prism 40, input side actuatable mirror 36 and input side focusing lens 46. Similarly, elements provided on the output side 50 of the wavelength selection system 30 may be referred to as output side elements. Thus, the wavelength selection system 30 comprises output side focusing lens 54, output side actuatable mirror 56, output side prism 60 and output side focusing lens 62.

Figures 9A and 9B schematically depict the filtering provided by the long pass filter when a roll-off of transmission is present (which may always be the case in practice). The roll-off is schematically depicted as extending across 30 nm. This is merely for illustrative purposes, and the shape and size of the roll-off may be significantly different in practice.

Figure 9A depicts a spatial position (in the Y-direction) on the long pass filter 32 which provides full transmission at 630 nm and transmission which rolls-off to around zero at 600 nm. A broadband radiation beam which has not undergone wavelength dispersion would be fully transmitted at wavelengths of 630 nm or more, and would be attenuated according to the roll-off at shorter wavelengths. Thus, in this example radiation at 615 nm would be 50% attenuated.

Figure 9B illustrates the effect of the long pass filter 32 on the dispersed radiation beam 38D (see Figure 7). Because the radiation beam is dispersed, radiation having a wavelength of 615 nm is incident at a different location on the long pass filter 32 than the radiation having a wavelength of 630nm. The wavelength distribution of the dispersed radiation beam increases in an opposite direction to the direction in which the filter transition wavelength of the long pass filter 32 increases. As a result, the beam wavelength of 615 nm is incident at a location on the long pass filter which transmits at longer wavelengths (compared with the location that received the beam wavelength of 630 nm). The long pass filter provides full transmission of wavelengths of 645 nm or more and provides around zero transmission at 615 nm. That is, the 615 nm radiation is not transmitted by the long pass filter 32. As noted above, if a non-dispersed beam was used then 50% of radiation at 615 nm would be transmitted. Thus, the dispersed radiation beam has provided a significantly improved roll-off of filter performance (the roll-off is steeper).

The example depicted in Figure 9 is merely a schematic illustrative example. It will be appreciated, that in general when the wavelength distribution of the dispersed radiation beam increases in an opposite direction to the direction in which the filter transition wavelength of the long pass filter 32 increases then the roll-off provided by the long pass filter is made steeper. The filtering performance is improved.

In the above example the rate of change of the wavelength of the dispersed radiation beam is the same as the rate of change of the filter transition wavelength of the long pass filter 32. However, the rate of change of the wavelength of the dispersed radiation beam may be different from the rate of change of the filter transition wavelength of the long pass filter 32. Filtering performance will still be improved in the manner described above.

The above also applies in the same way to the filtering performance of the short pass filter 34.

The above example relates to specific wavelengths. However, the filter pair 32, 34 may provide filtering for example over a range of 400 nm to 1600 nm, or a range of 500 nm to 1050 nm, or a range of 450 nm to 900 nm.

The wavelength distribution of the dispersed radiation beam may be arranged to increase in the same direction as the direction in which the filter transition wavelength of the filter pair 32, 34 increases. However, this will provide a reduced filtering performance.

The controller CT may be arranged to move the high pass optical filter in the wavelength selecting direction (generally perpendicular to the optical axis) using an actuator controlled by the controller. In general, where a filter pair is used, movement of a filter of the filter pair in the wavelength selecting direction (generally perpendicular to the optical axis) may be used to select a bandwidth of radiation transmitted by the filter pair. The movement may be controlled by the controller CT. The front filter or the rear filter may be moved. Both filters may be moved.

The effect of moving a filter may be understood with reference to Figure 8. The bandwidth of radiation transmitted by the filter pair is determined by the offset between the short pass filter 34 and the long pass filter 32. Increasing the offset will increase the bandwidth and decreasing the offset will reduce the bandwidth. The change of offset may be achieved by moving the front filter and/or the rear filter.

Moving one of the filters will change the center wavelength of the radiation transmitted by the filter. For example, if the front filter 32 is not moved (i.e. X nm stays the same as in Figure 8) and the rear filter 34 to increase the bandwidth (e.g. to a bandwidth of 30 nm), the center wavelength is increased (in this example the center wavelength has increased by 5 nm). A shift of the center wavelength may be avoided by moving both the front filter 32 and the rear filter 34 by the same amount.

The term "continuously variable optical filter" may be interpreted as meaning an optical filter with wavelength transmission which varies continuously as a function of position on the optical filter.

The continuously variable low pass optical filter 32 and continuously variable high pass optical filter 34 are an example of an optical filter arrangement that may form part of an embodiment of the invention. A different optical filter arrangement may be used. For example, a bandpass filter may be used. Different locations on the bandpass filter may be transmissive for different wavelengths of radiation. The optical filter, instead of having wavelength transmission that is continuously variable, may have wavelength transmission that varies in a series of steps (although this would provide less tunability) In general, any form of optical filter that selectively filters different wavelengths of a radiation beam at different locations may be used.

The optical filter may be transmissive. Alternatively the optical filter may be reflective. The optical filter may for example be a Bragg reflector. The Bragg reflector may have a gradient of quarter wave stack period which varies along the reflector (in the Y-direction). This provides a continuously variable optical filter. A disadvantage of a Bragg reflector compared with a filter pair of the type described further above is that the Bragg reflector doesn't provide tunability of the bandwidth of filtered radiation in the way that the filter pair 32, 34 does. In another example a reflective filter may comprise a transmissive filter provided on a mirror. Where such an arrangement is used, the filter and mirror may be angled relative to an incident radiation beam to avoid reflection of the beam back along the incident direction.

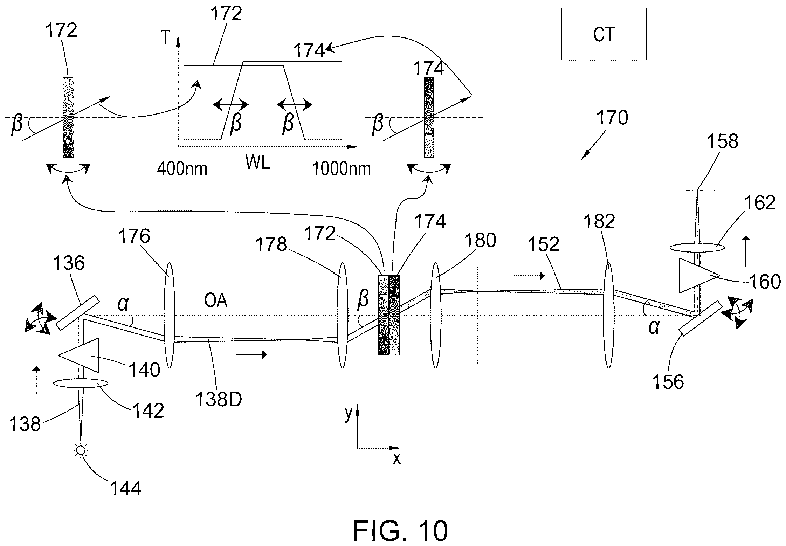

An alternative embodiment of the invention is schematically depicted in Figure 10. Figure 10 includes some elements which correspond with the elements depicted in Figure 7. Where this is the case the same reference numerals are used, but incremented by 100. The wavelength selection system 170 comprises a filter pair which consists of a short pass filter 172 and a long pass filter 174. In the embodiment depicted in Figure 7, the wavelength filtering provided by a filter pair is determined by the position at which the radiation beam is incident upon the filter pair. In the embodiment depicted in Figure 10, the wavelength filtering provided by the filter pair 172, 174 is determined by the angle of incidence of the radiation beam at the filter pair.

The operation of the filter pair 172, 174 is schematically depicted by a graph at the top of Figure 10. A dispersed radiation beam 138D is incident upon the filter pair 172, 174. The short pass filter 172 has a transition from transmitting to blocking which is dependent upon the angle of incidence β of the incident radiation beam 138D. As indicated in the graph, the filter transition wavelength increases and decreases as the angle β is increased and decreased. In common with the filter transitions depicted in Figures 9A and 9B, the filter transition is not a step function but instead has a roll-off (i.e. the transition is gradual). Nevertheless, for ease of terminology the filter transmission may be referred to as having a filter transition wavelength. In the context of a filter with a roll-off, the filter transition wavelength may be considered to be the wavelength at which transmission is at 50%.

Similarly, the long pass filter 174 is blocking at short wavelengths and transmits at long wavelengths. A filter transition wavelength of the long pass filter 174 is determined by the angle of incidence β of the radiation beam as schematically depicted.

Referring to the bottom portion of Figure 10, the wavelength selection system 170 comprises an actuatable mirror 136 which is moveable between different orientations which direct a radiation beam 138D to different locations on a first input side lens 176. The first input side lens 176 is located a focal length away from the actuatable mirror 126. As a result, the radiation beam 138 is collimated by the first input side lens 176 such that it travels parallel to the optical axis OA of the wavelength selection system 170. A second input side lens 178 receives the collimated radiation beam 138D. The second input side lens 178 is located a focal length away from the filter pair 172, 174. The second input side lens 178 directs the radiation beam 138D onto the filter pair 172, 174 at or adjacent to the optical axis OA of the wavelength selection system. The radiation beam 138D is incident with an angle of incidence which depends on the spatial position at which the radiation beam 138 was incident at the second input side lens 178. Movement of the actuatable mirror 136 may be controlled by a controller CT.

An angle α subtended by the radiation beam 138D as it travels from the actuatable mirror 136 to the input side lens 176 may differ from the angle of incidence β of the radiation beam at the filter pair 172, 174. This difference may be due to the first input side lens 176 having a different focal length to the second input side lens 178. In an embodiment, the first input side lens 176 and second input side lens 178 combine to image the dispersed radiation beam 138D from the actuatable mirror 136 to the filter pair 172, 174. The focal length of the second input side lens 178 may be less than the focal length of the first input side lens 176, so that a demagnification is applied. This increases the angle β at the filter pair 172, 174, allowing for a wider range of incident angles at the filter pair.

A prism 140 is provided upstream of the actuatable mirror 136. The prism 140 is configured to disperse a radiation beam 138 into component wavelengths and thereby form a dispersed radiation beam 138D. For ease of illustration the dispersion is not depicted in Figure 10.

The wavelength selection system 170 further comprises a beam conditioning lens 142 provided upstream of the prism 140. The beam conditioning lens 142 may for example be configured to collimate the input radiation beam 138. The radiation beam 138 may be provided by a source 144. Properties of the source 144 may be as set out further above in connection with Figure 7.

In use, the wavelength selection system 170 is operated in the same way as the wavelength selection system described further above in connection with Figure 7. That is, a desired wavelength (which in practice may be a central wavelength and associated bandwidth) may be selected using the actuatable mirror 136. Moving the actuatable mirror 136 changes the angle of incidence β of the dispersed radiation beam 138D on the filter pair 172, 174 thereby changing the wavelength that is transmitted by the filter pair.

The dispersed radiation beam 138D may have a wavelength distribution in which the wavelength increases in an opposite direction to the direction in which the filter transition wavelength of the filter pair 172, 174 increases. For the reasons described further above, this may improve the wavelength selectivity provided by the wavelength selection system 170.

An output side of the wavelength selection system 170 comprises a first output side lens 180 and a second output side lens 182. The configuration of these lens 180, 182 corresponds with configuration of the lens 176, 178 on the input side and is not described again. An actuatable mirror 156 receives the filtered radiation beam, which may be referred to as the output beam 152 and directs the output beam through a prism 160 and lens 162 to an output location 158. Movement of the actuatable mirror 156 may be controlled by a controller CT. The prism 160 may be configured to reverse remaining dispersion of the output beam 152. The lens 162 may be configured to focus the output beam 152 to the output location 158. An optical fiber may be provided at the output location 158.

Although the long pass filter 174 is shown as being parallel to the short pass filter 172, the short pass filter may be at an angle relative to the long pass filter. This angle may determine a bandwidth of radiation transmitted by the filter pair 172, 174. The angle may be adjusted by rotating the long pass filter 174 using an actuator. The rotation may be controlled by the controller CT.

In an embodiment, a plurality of filter pairs may be provided. The plurality of filter pairs may be separated in the Z-direction. A different angle may be subtended between filters of each pair of filters. This may allow selection of different bandwidths of filtered radiation by moving the radiation beam 138D in the Z-direction.

Angle of incidence based filters are available for example from IDEX Corporation of Illinois, USA.

Advantageously, the dispersed radiation beam 138D is distributed when it is incident upon the filter pair 172, 174. This reduces intensity of radiation at the filter pair, so reducing the likelihood of damage being caused. The radiation beam 138D may be collimated at the filter pair 172, 174 (as schematically illustrated in Figure 10). This reduces the intensity of the radiation beam 138D at the filter pair 172, 174 thereby reducing a risk of the radiation beam causing damage to the filter pair.

Features of embodiments described further above may also be combined with the embodiment depicted in Figure 10. For example, the different filters may be provided next to each other in the Z-direction. For example, the order of the filters of the filter pair 172, 174 may be reversed. For example, an angle of incidence based filter or filters may have a different configuration.

In the above description the input side prism 40 is located upstream of the actuatable mirror 36. However, in an alternative arrangement the input side prism may be located downstream of the actuatable mirror. A beam propagation path length is needed for dispersion of wavelengths of the radiation beam after the prism, and if the mirror is located before the prism then the total path length from the mirror to the optical filter may need to be increased. With this arrangement it may be more difficult to control, using the actuatable mirror, a position at which the radiation beam is incident upon the optical filter for this longer optical path length. However, a benefit of this arrangement is that the longer path length means that a smaller movement of the actuatable mirror may be sufficient to move the radiation beam between desired locations on the optical filter, meaning that the actuatable mirror may have a faster settling time.

In an embodiment, the prism 40 may be actuatable. Actuation of the prism 40 may be used to modify the wavelength dispersion that is applied to the radiation beam 38. This may allow tuning of the bandwidth of radiation that is transmitted by the filter pair 32, 34. The actuation may for example be rotation about an axis which extends in the Z-direction. This rotation may be used to control the wavelength dispersion provided by the prism 40. This in turn may provide tuning of the bandwidth of radiation that is transmitted by the filter pair 32, 34. The actuation may be controlled by the controller CT. In an embodiment, actuation of the prism 40 may comprise moving the prism generally perpendicular to the radiation beam (in the X-direction), such that the radiation beam 38 has a longer or shorter path length through the prism. This may also control the wavelength dispersion that is applied to the radiation beam 38, and may also allow tuning of the bandwidth of radiation that is transmitted by the filter pair 32, 34.

The orientation of the input side actuatable mirror 36 may for example be controlled using electrostatic actuation. Alternatively, the orientation of the input side actuatable mirror may be controlled using a piezo electric actuator.

Although a prism 40 is provided on the input side 48 of the wavelength selection system 30 a different dispersive element may be used. For example, a grating may be used. The grating may be reflective or transmissive. The wavelength dispersion provided by the dispersive element may be linear or nonlinear. The same applies for the output side 50 of the wavelength selection system 30.

The actuatable mirrors 36, 56 are examples of actuatable reflectors. Other actuatable reflectors may be used.

Embodiments of the invention may advantageously provide a radiation source that is able to switch quickly between desired wavelengths via actuation of the actuatable mirror 36 (which may be controlled by the controller CT). Embodiments of the invention may advantageously provide improved filter performance compared with filter performance for a radiation beam which is not wavelength dispersed. Because the radiation beam 38D is dispersed when it is incident upon the filter pair 32, 34 the intensity of radiation at the filter pair is reduced. This advantageously reduces a risk of damage being caused to the filter pair 32, 34. This may be particularly important for a pulsed radiation beam in which a burst of pulses is used, because the burst of pulses will deliver a large amount of power to the filter pair 32, 34 in a short period of time. The same applies for other optical filters.

Further embodiments are disclosed in the following list of numbered clauses:
1. A wavelength selection system comprising:
   an actuatable reflector configured to reflect a radiation beam, and an optical filter configured to receive the reflected radiation beam;
   wherein the actuatable reflector is moveable between different orientations which direct the radiation beam to different positions on the optical filter, or at different angles of incidence on the optical filter,
   such that the optical filter selectively filters different wavelengths of the radiation beam; and
   wherein the wavelength selection system further comprises a dispersive element configured to apply wavelength dispersion to the radiation beam before the radiation beam is incident upon the optical filter.
2. The wavelength selection system of clause 1, wherein the optical filter is a continuously variable optical filter having a wavelength transmission which varies continuously as a function of position on the optical filter.
3. The wavelength selection system of clause 2, wherein the dispersive element is configured to provide the radiation beam with a wavelength distribution which increases in an opposite direction to a direction in which a filter transition wavelength of the continuously variable optical filter increases.
4. The wavelength selection system of clause 2 or clause 3, wherein the continuously variable optical filter is one of a pair of continuously variable optical filters that are provided in series.
5. The wavelength selection system of clause 4, wherein at least one of the continuously variable optical filters is actuatable in a direction which is generally perpendicular to an optical axis of the wavelength selection system.
6. The wavelength selection system of clause 1, wherein the optical filter provides filtering determined by an angle of incidence of the radiation beam, and wherein a pair of focusing lenses are provided between the actuatable reflector an the optical filter.
7. The wavelength selection system of clause 6, wherein the pair of focusing lenses are configured to form a demagnified image of the radiation beam at the actuatable reflector.
8. The wavelength selection system of any preceding clause, wherein the actuatable reflector is configured to move the radiation beam in two dimensions.
9. The wavelength selection system of clause 8, wherein the optical filter is one of a plurality of optical filters selectable through movement of the radiation beam by the actuatable reflector.
10. The wavelength selection system of any preceding clause, wherein the dispersive element is located upstream of the actuatable reflector.
11. The wavelength selection system of any preceding clause, wherein the dispersive element is a prism.
12. The wavelength selection system of clause 11, wherein the prism is actuatable.
13. The wavelength selection system of clause 12, wherein the prism is rotatable and/or moveable in a direction generally perpendicular to the radiation beam.
14. The wavelength selection system of any of clauses 1 to 10, wherein the dispersive element is a grating.
15. The wavelength selection system of any preceding clause, wherein the wavelength selection system further comprises a second actuatable reflector located downstream of the optical filter, the second actuatable reflector being configured to direct a filtered radiation beam received from the optical filter to an output location.
16. The wavelength selection system of any preceding clause, wherein the wavelength selection system further comprises a second dispersive element located downstream of the optical filter, the second dispersive element being configured to remove or reduce any wavelength dispersion present in the filtered radiation beam received from the optical filter.
17. A metrology tool comprising the wavelength selection system of any preceding clause.
18. A lithographic apparatus comprising the wavelength selection system of clause 16 or the metrology tool of clause 17.
19. A method comprising using an actuatable reflector to direct a radiation beam onto an optical filter, the radiation beam being incident on the optical filter at a position or with an angle of incidence that is selected via an orientation of the actuatable reflector, such that the optical filter selectively filters different wavelengths of the radiation beam;
   wherein the method further comprises applying a wavelength dispersion to the radiation beam before the radiation beam is incident upon the optical filter.
20. The method of clause 19, wherein the optical filter is a continuously variable optical filter having a wavelength transmission which varies continuously as a function of position on the optical filter.
21. The method of clause 19 or clause 20, wherein the dispersive element provides the radiation beam with a wavelength distribution which increases in an opposite direction to a direction in which a filter transition wavelength of the continuously variable optical filter increases.
22. The method of any of clause 19 to 21, wherein the continuously variable optical filter is one of a pair of continuously variable optical filters that are provided in series.
23. The method of any of clauses 19 to 22, wherein the method further comprises moving at least one of the continuously variable optical filters in a direction which is generally perpendicular to an optical axis of the wavelength selection system to adjust a bandwidth of radiation transmitted by the continuously variable optical filters.
24. The method of any of clauses 19 to 23, wherein the optical filter provides filtering determined by an angle of incidence of the radiation beam, and wherein a pair of focusing lenses are provided between the actuatable reflector an the optical filter.
25. The method of clause 24, wherein the pair of focusing lenses form a demagnified image of the radiation beam at the actuatable reflector.
26. The method of any of clauses 19 to 25, wherein the actuatable reflector moves the radiation beam in two dimensions.
27. The method of clause 26, wherein the optical filter is one of a plurality of optical filters selectable through movement of the radiation beam by the actuatable reflector.
28. The method of any of clauses 19 to 27, wherein the dispersive element is located upstream of the actuatable reflector.
29. The method of any of clauses 19 to 28, wherein the dispersive element is a prism.
30. The method of any of clauses 19 to 29, wherein the prism is actuatable rotatable and/or moveable in a direction generally perpendicular to the radiation beam.
31. The method of any of clauses 19 to 28, wherein the dispersive element is a grating.
32. The method of any of clauses 19 to 31, wherein the method further comprises using a second actuatable reflector located downstream of the optical filter to direct a filtered radiation beam received from the optical filter to an output location.
33. The method of any of clauses 19 to 32, wherein the method further comprises using a second dispersive element located downstream of the optical filter to remove or reduce any wavelength dispersion present in the filtered radiation beam received from the optical filter.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology tool, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

## Claims

1. A wavelength selection system comprising:
an actuatable reflector configured to reflect a radiation beam, and an optical filter configured to receive the reflected radiation beam;
wherein the actuatable reflector is moveable between different orientations which direct the radiation beam to different positions on the optical filter, or at different angles of incidence on the optical filter, such that the optical filter selectively filters different wavelengths of the radiation beam; and
wherein the wavelength selection system further comprises a dispersive element configured to apply wavelength dispersion to the radiation beam before the radiation beam is incident upon the optical filter.

2. The wavelength selection system of claim 1, wherein the optical filter is a continuously variable optical filter having a wavelength transmission which varies continuously as a function of position on the optical filter.

3. The wavelength selection system of claim 2, wherein the dispersive element is configured to provide the radiation beam with a wavelength distribution which increases in an opposite direction to a direction in which a filter transition wavelength of the continuously variable optical filter increases.

4. The wavelength selection system of claim 2 or claim 3, wherein the continuously variable optical filter is one of a pair of continuously variable optical filters that are provided in series.

5. The wavelength selection system of claim 4, wherein at least one of the continuously variable optical filters is actuatable in a direction which is generally perpendicular to an optical axis of the wavelength selection system.

6. The wavelength selection system of any preceding claim, wherein the actuatable reflector is configured to move the radiation beam in two dimensions.

7. The wavelength selection system of claim 6, wherein the optical filter is one of a plurality of optical filters selectable through movement of the radiation beam by the actuatable reflector.

8. The wavelength selection system of any preceding claim, wherein the dispersive element is located upstream of the actuatable reflector.

9. The wavelength selection system of any preceding claim, wherein the dispersive element is a prism.

10. The wavelength selection system of claim 9, wherein the prism is actuatable.

11. The wavelength selection system of any preceding claim, wherein the wavelength selection system further comprises a second actuatable reflector located downstream of the optical filter, the second actuatable reflector being configured to direct a filtered radiation beam received from the optical filter to an output location.

12. The wavelength selection system of any preceding claim, wherein the wavelength selection system further comprises a second dispersive element located downstream of the optical filter, the second dispersive element being configured to remove or reduce any wavelength dispersion present in the filtered radiation beam received from the optical filter.

13. A metrology tool comprising the wavelength selection system of any preceding claim.

14. A lithographic apparatus comprising the wavelength selection system of claim 12 or the metrology tool of claim 13.

15. A method comprising using an actuatable reflector to direct a radiation beam onto an optical filter, the radiation beam being incident on the optical filter at a position or with an angle of incidence that is selected via an orientation of the actuatable reflector, such that the optical filter selectively filters different wavelengths of the radiation beam;
wherein the method further comprises applying a wavelength dispersion to the radiation beam before the radiation beam is incident upon the optical filter.
